# EUROPEAN PATENT APPLICATION

(11) **EP 1 750 368 A1**
(43) Date of publication of application: **07.02.2007**
(21) Application number: 05254864.1
(22) Date of filing: 04.08.2005
(51) Int. Cl.: H03H 1/00, H05K 9/00

(54) **Ferrite bead EMI suppressor**

(71) Applicant: King Core Electronics Inc., Taoyuan Hsien (TW)
(72) Inventor: Yang, Cheng-Li, Taipei (TW); Chen, Cheng-Han, Taipei (TW)
(74) Representative: Gee, Steven William

(57) **Abstract**

A ferrite bead EMI suppressor is provided. The construction of the EMI suppressor makes use of a ferrite bead split into two half shells. The internal wall of each half is embedded with split ferrite bead. Two semi-circular gaps are formed on two ends of each half shell, and an I-bar in the middle of the cavity portion. The two adjacent sides of the two halves are locked by a pair of catches, while the other two adjacent sides of the two halves are joined by a pair of hinges when the ferrite bead is strung on a round cable. This construction allows a section of the cable to be safely held in the internal cavity of the ferrite bead, thus the space utilization and cable management can be enhanced at the same time.

## Description

### BACKGROUND OF THE INVENTION

### 1. Field of the Invention

The present invention relates to an EMI suppressor, and in particular to a one-loop or multi-loop ferrite bead that is retrofitted on a round cable for enhanced EMI suppression.

### 2. The Related Art

As the digital computers and electronic devices are continuously upgraded, their high operating frequencies makes the components increasingly susceptible to noise interference, the bulk of which comes from EMI. The significance of the noise level is related to the frequencies of signals/current transmitted through the cables.

Scientists around the world have studied the health effects of exposure to radio waves and EMI. A number of international recognized standards organizations have established RF safety standards and acceptable levels of EMI radiation that provide substantial margins of protection for users and the public. The electronic manufacturers have an important task that is how to suppress EMI on their electronic products, so that their products are able to meet the specifications for the major markets.

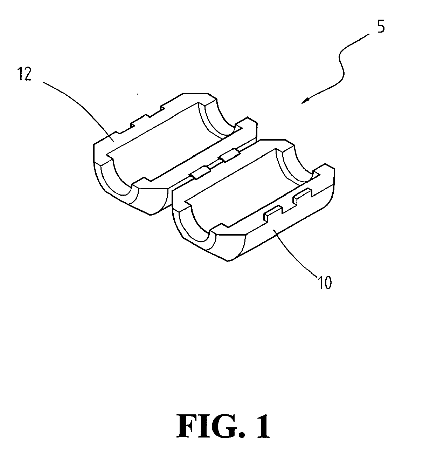

Referring to FIG 1, the conventional EMI suppressor is formed by a ferrite core 5 split into two halves: a first half 10 and a second half 12, where each half has two semi-circular gaps on two ends to form a hole through the middle of the ferrite core 5. Two adjacent sides of the two halves are joined by a hinge, while the other two adjacent sides of the two halves are fastened by a catch when the two halves 10, 12 are clipped onto a round cable. This ferrite core 5 is made of ceramic (metal oxide) material by reacting metal oxides at high temperature into a magnetic (ferrite) material. Soft magnetic (ferrite) material has the advantage that it can be easily magnetized for storing magnetic energy so as to create impedance against high frequency EMI.

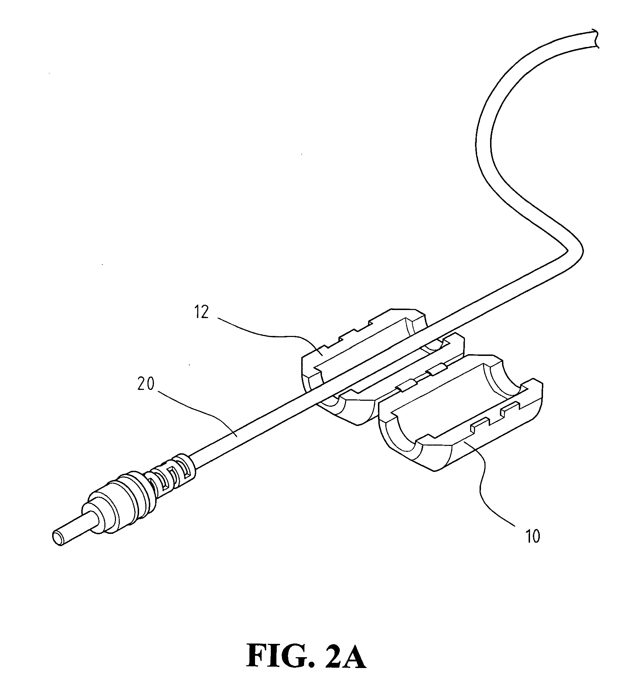

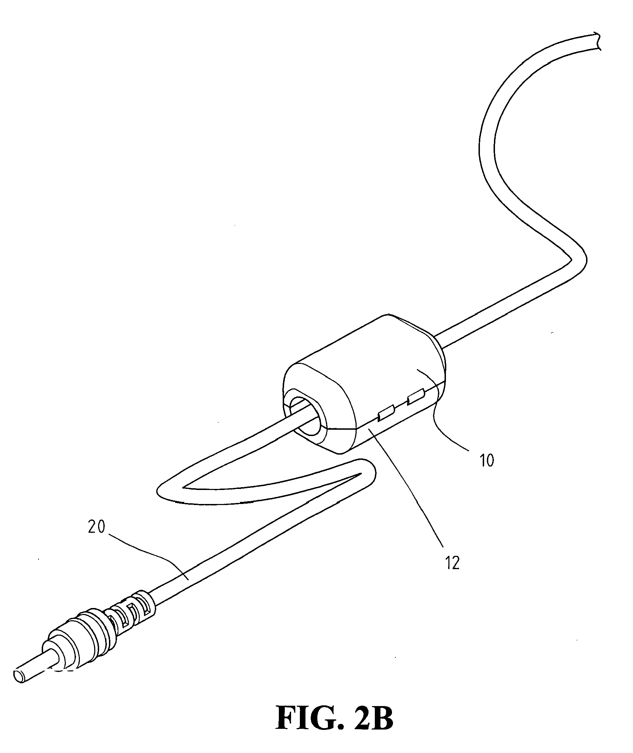

Referring to FIGS. 2A, 2B, the ferrite core 5 is strung on a round cable 20 by fitting the cable 20 into the middle cavity of either one of the split halves 10, 12 and then clipping together the two halves 10, 12 combined to form an EMI suppressor (ferrite core) around the cable.

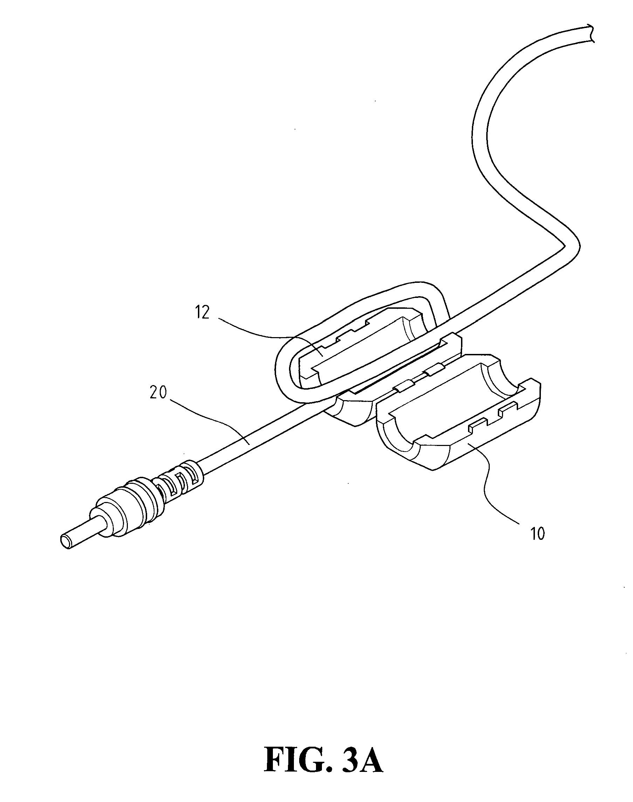

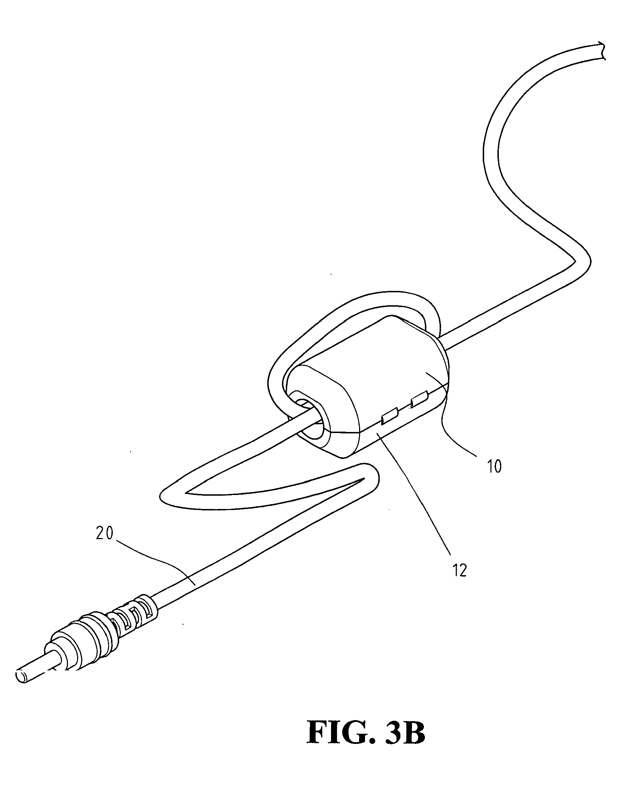

Referring to FIGS. 3A, 3B, a one-loop configuration ferrite core 5 is designed that is able to enhance the EMI suppression effect (increase impedance). The cable 20 is fed through the two holes on two ends and wound around the middle of the ferrite core 5 to create a loop as the ferrite core 5 is strung on the cable 20.

Although the use of a cable loop can substantially improve the EMI suppression capability of the ferrite core 5, this one-loop configuration is rarely found on conventional EMI suppressors 5. Even then, the partly exposed cable tends to spoil the appearance of the ferrite core and may run the risk of messing up the cable assembly.

In these aspects, the ferrite core EMI suppressor according to the present invention substantially reduces or obviates the limitations and disadvantages of the prior art.

### SUMMARY OF THE INVENTION

The primary objective of the invention is to provide a ferrite bead EMI suppressor that makes use of upper and lower I-bars to form a cable loop in the middle of the internal cavity through which the EMI suppression capability can be substantially improved.

The second objective of the invention is to provide a ferrite bead EMI suppressor that promotes high efficiency space utilization, while keeping the cable assembly neat and orderly.

The third objective of the invention is to provide a ferrite bead EMI suppressor that can enhance the appearance of the cable assembly even when a ferrite bead is strung thereon.

To attain the above-mentioned objectives, the ferrite bead EMI suppressor is formed by a first half shell, a second half shell, and a cavity through the middle, where the internal wall of each half is embedded with split ferrite bead; two semi-circular gaps are formed on two ends of each half shell and an I-bar in the middle separating the cavity portion, which corresponds to another column extending from the opposite wall.

The present design allows a section of the cable to be looped around and anchored by upper and lower I-bars as the cable passes through the ferrite bead. This construction has an advantage that it can safely conceal the cable loop in the ferrite bead, neither altering the appearance nor increasing the size of the EMI suppressor.

These along with other features of novelty which characterize the invention, are pointed out with particularity in the claims annexed to and forming a part of this disclosure. For a better understanding of the invention, the operating advantages and the specific objectives attained by its uses, references should be made to the accompanying drawings and descriptive matter illustrated in preferred embodiments of the invention.

### BRIEF DESCRIPTION OF THE DRAWINGS

FIG 1 is a split view of the conventional EMI suppressor;
FIG. 2A is a split view of the conventional EMI suppressor with a round cable passing through the middle;
FIG. 2B is the conventional EMI suppressor clipping on the round cable;
FIG. 3A is a split view of the conventional EMI suppressor with a round cable passing through and a cable loop around the ferrite core;
FIG 3B is the conventional EMI suppressor with a cable loop exposed after clipping onto the round cable;
FIG. 4 shows the construction of a ferrite bead EMI suppressor in accordance with the present invention;
FIG 5A is a split view of a ferrite bead EMI suppressor with a cable loop fitted in the middle cavity; and
FIG 5B shows the ferrite bead EMI suppressor retrofitting on a round cable.

### DETAILED DESCRIPTION OF THE PREFERRED EMBODIMENT

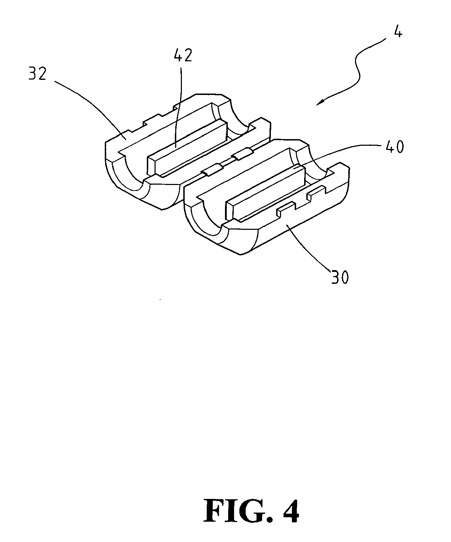

Referring to FIG. 4, the ferrite bead EMI suppressor is formed by a first half shell 30, a second half shell 32, and a cavity in the middle. The ferrite bead 4 is used to suppress EMI radiation when retrofitted on a cable assembly. The internal wall of each half shell 30/32 is embedded with split ferrite bead. Two semi-circular gaps are formed on two ends of each half shell 30/32 and an I-bar 40/42 in the middle separating the cavity portion.

When the two half shells 30, 32 are combined, a hole is formed through the middle of the ferrite bead 4. The present design allows a section of the cable 20 to be wound and held by the upper and lower I-bars 40, 42 in the middle of the ferrite bead 4 to form a single loop as the cable 20 passes through the ferrite bead 4.

The ferrite bead 4 has a composition of metal oxide and iron oxide such as Nickel-Zinc ferrite and Manganese-Zinc ferrite.

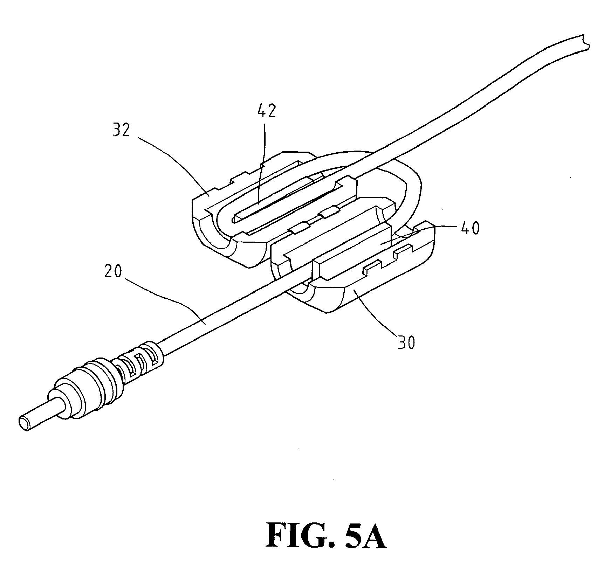

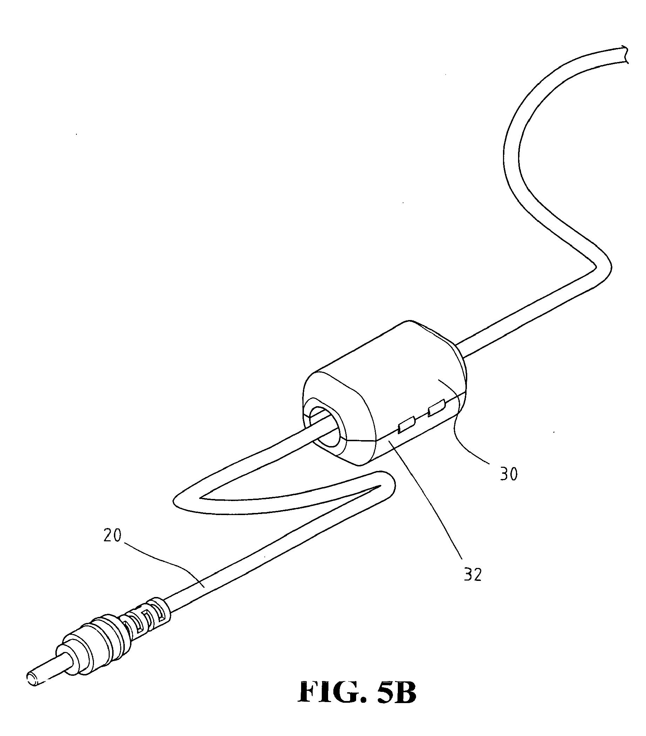

Referring to FIGS. 5A, 5B, as the ferrite bead 4 is strung on the cable 20, a section of the cable 20 is wound around the I-bar 42 on the second half shell 32 to form one cable loop, and then the cable 20 is bent around and returned through the middle of the first half 30, passing through I-bar 40, before exiting from the opposite end of the ferrite bead 4. Or else, the section of the cable 20 can be wound around I-bar 40 on the first half shell 30 to form a cable loop. Likewise, the cable 20 is bent around and passed through the middle of the second half shell 32 and I-bar 42. Thereafter, the two halves 30, 32 are combined to allow the ferrite bead 4 to be retrofitted onto the cable 20.

With a single loop configuration, the ferrite bead 4 does not necessarily have to be enlarged in order to fit in the cable loop. However, the number of turns can be increased by creating additional I-bars in the internal space of the ferrite bead 4, that means the I-bars in the middle of the first and second half shells have to be increased with each numbers. In such a case, the effect of EMI suppression can be further improved, but then, the resistivity and curie temperature are also factors to be considered altogether.

Since the cable loops are stored within the internal cavity of the ferrite bead 4, this facilitates the space utilization around the electronic device, whereas the conventional EMI suppressor 5 has the cable 20 half exposed on the outside. Also, the ferrite bead 4 can be strung on the cable 20 in an orderly manner, with no risk of messing up the cable assembly.

Although the present invention has been described with reference to the preferred embodiments thereof, it is apparent to those skilled in the art that a variety of modifications and changes may be made with regard to different forms and shapes without departing from the spirit and scope of the present invention which is intended to be defined by the appended claims.

## Claims

1. An EMI suppressor for retrofitting on a round cable, comprising:
a first half shell having an internal wall embedded with split ferrite bead, two semi-circular gaps on two ends, and an I-bar in the middle separating a cavity portion; and
a second half shell having an internal wall embedded with split ferrite bead, two semi-circular gaps on two ends, and an I-bar in the middle, corresponding to the other I-bar extending from the opposite wall, separating the cavity portion;
wherein two adjacent sides of the two halves are fastened by a pair of catches, while the other two adjacent sides of the two halves are joined by a pair of hinges when the two halves are combined; and
a hole is formed through the middle of the ferrite bead when the two semi-circular gaps on two complementary halves are combined, through which a cable is fed in and one cable loop is formed by winding the cable around the upper and lower I-bars in the internal cavity as the cable passes through the ferrite bead from one end to the other.

2. The EMI suppressor as claimed in claim 1, wherein the cable is an electronic signal cable.

3. The EMI suppressor as claimed in claim 1, wherein the cable is an electric/power cable.

4. The EMI suppressor as claimed in claim 1, wherein the number of I-bars in the middle of the first half shell is to be increased, so that the EMI suppression capability can be further enhanced.

5. The EMI suppressor as claimed in claim 1, wherein the number of I-bars in the middle of the second half shell is to be increased, so that the EMI suppression capability can be further enhanced.

6. The EMI suppressor as claimed in claim 1, wherein the ferrite bead is made of Nickel-Zinc ferrite.

7. The EMI suppressor as claimed in claim 1, wherein the ferrite bead is made of Manganese-Zinc ferrite.
